# EUROPÄISCHE PATENTSCHRIFT

(11) **EP 1 607 492 B1**
(45) Veröffentlichungstag und Bekanntmachung des Hinweises auf die Patenterteilung: **12.09.2007**
(21) Anmeldenummer: 04013028.8
(22) Anmeldetag: 02.06.2004
(51) Int. Cl.: C23C 14/56, B65H 35/02

(54) **Bandbehandlungsanlage mit mindestens einer Vakuumkammer**
Strip treatment apparatus with at least one vacuum chamber
Installation de traitement de bandes ayant au moins une chambre à vide

(43) Veröffentlichungstag der Anmeldung: 21.12.2005
(73) Patentinhaber: Applied Materials GmbH & Co. KG, 63755 Alzenau (DE)
(72) Erfinder: Hein, Stefan, 63825 Blankenbach (DE); Gerber, Gunther, 63776 Mömbris (DE)
(74) Vertreter: GROSSE BOCKHORNI SCHUMACHER

(56) Entgegenhaltungen:
- US-A- 3 044 438
- US-A- 5 447 748
- PATENT ABSTRACTS OF JAPAN Bd. 1997, Nr. 05, 30. Mai 1997 (1997-05-30) -& JP 09 016950 A (VICTOR CO OF JAPAN LTD), 17. Januar 1997 (1997-01-17)
- PATENT ABSTRACTS OF JAPAN Bd. 1995, Nr. 07, 31. August 1995 (1995-08-31) & JP 07 098868 A (KAO CORP), 11. April 1995 (1995-04-11)
- PATENT ABSTRACTS OF JAPAN Bd. 2000, Nr. 14, 5. März 2001 (2001-03-05) & JP 2000 327186 A (SONY CORP), 28. November 2000 (2000-11-28)

## Beschreibung

Die Erfindung bezieht sich auf eine Bandbehandlungsanlage, insbesondere eine Anlage zum Beschichten von Bahnmaterial, mit den Merkmalen des Oberbegriffs des Patentanspruchs 1.

Derartige Anlagen sind in mannigfachen Ausführungen bekannt (vgl. z. B. WO 99/50 472, EP 1 306 888 A2). Sie dienen zum Behandeln, insbesondere zum Beschichten von flexiblen Bandsubstraten, z. B. Kunststofffolien, Magnetbändern, Filmen etc., im Vakuum (z. B. durch Sputtern, also Zerstäuben von Targets, das ggf. von Magnetfeldern unterstützt wird, Aufdampfen, PVD- oder CVD-Verfahren), aber auch zu weiteren Behandlungsformen wie Vorbehandlungen / Reinigen / Trocknen / Oberflächenaktivieren / Polymerisation etc..

Es kann erforderlich werden, das fertig behandelte Bahn- oder Bandmaterial in Längsrichtung zu schneiden, um z. B. seine Ränder abzutrennen und eine definierte Bandbreite herzustellen, oder um mehrere gleich oder unterschiedlich breite Bahnen jeweils unabhängig voneinander aufzuwickeln oder weiteren Behandlungsschritten zuzuführen.

Bislang werden die entsprechenden Schneidestationen oder -anlagen außerhalb der Bandbehandlungsanlagen stromab des eigentlichen Behandlungs- oder Beschichtungstraktes angeordnet (stromab bedeutet hier in Laufrichtung des Bandmaterials gesehen, während stromauf entgegen der Laufrichtung des Bandmaterials bedeutet). Beispiele für solche Anlagen sind z. B. aus EP 1 334 936 A1 oder DE-OS 1 932 341 bekannt. Letztere Druckschrift beschreibt eine Rollenschneide- und Umwickelmaschine, bei der eine Papierbahn über eine erste Breitstreckwalze in den Bereich einer aus Ober- und Untermesser bestehenden Längsschneidevorrichtung geführt wird und nach dem Schneiden über eine zweite Breitstreckwalze zu einer Aufwickelrolle gelangt.

Unter Breitstreckwalze versteht man eine Walze oder Rolle, auf der eine darüber geführte Bahn durch Kontakt mit einer speziellen Oberfläche der Walze in Querrichtung so gestreckt wird, dass jegliche Längsfalten vermieden oder auch geglättet werden. Derartige Walzen sind an sich ebenfalls allgemein bekannt (vgl. nur beispielsweise DE 38 90 004 C1).

JP 9 016 950 A zeigt eine Bandbeschichtungsanlage, wobei innerhalb einer Vakuum-Kammer eine Einrichtung zum kontinuierlichen Längsschneider des Bandmaterials vorgesehen ist.

Der Erfindung liegt die Aufgabe zu Grunde, eine Bandbehandlungsanlage mit mindestens einer zusätzlichen Funktion zu schaffen, die es ermöglicht, die Gesamtlänge einer Behandlungsanlage zu reduzieren.

Diese Aufgabe wird erfindungsgemäß mit den Merkmalen des Patentanspruchs 1 gelöst. Die Merkmale der Unteransprüche geben vorteilhafte Weiterbildungen der Erfindung an.

Man sieht demnach eine Längsschneideeinrichtung bzw. einen entsprechend ausgestatteten Modul unmittelbar in einem Vakuum-Behandlungsbereich der Bandbehandlungsanlage vor, so dass diese Einrichtung integraler Bestandteil der eigentlichen Behandlungsanlage wird. Damit kann das Bandmaterial unmittelbar z. B. nach einer soeben erfolgten Beschichtung längs gespalten und in mindestens zwei getrennten Bahnen weiter geführt werden. Diese Bahnen können vorteilhaft gleich darauf folgend noch in der Anlage aufgewickelt werden, ggf. ebenfalls noch unter Vakuum, so dass das Risiko einer Verunreinigung zwischen dem Verlassen des Vakuumbereichs und dem Schneidevorgang einerseits und dem Aufwickelvorgang andererseits minimiert wird. Eventuelle sich beim Schneidevorgang bildende Partikel werden im Vakuum unter Schwerkraft sehr viel einfacher von dem Bandmaterial zu entfernen sein als in einer belüfteten Umgebung, die solche kleinen Partikel eher in der Schwebe halten und auf dem Bandmaterial unerwünscht ablagern könnte. Weiterhin wird wenigstens eine Breitstreckwalze vorgesehen.

Selbstverständlich kann man einerseits mehrere parallel angeordnete Messer oder Klingen vorsehen, um das Bandmaterial in mehr als zwei Bahnen längs zu unterteilen, andererseits kann das Messer oder können die Messer auch beweglich angeordnet sein, um sie bei Bedarf aus der Durchlaufebene des Bahnmaterials zu entfernen und dieses entweder ungeschnitten oder in einer beliebigen Anzahl von gleich oder unterschiedliche breiten Bahnen zu erhalten.

In einer vorteilhaften Ausgestaltung führt man das durchlaufende Bandmaterial wenigstens stromab der Längsschneideeinrichtung über eine Breitstreckwalze. Man kann damit insbesondere die nach dem Schnitt längs geteilten Bahnen wenigstens geringfügig auseinander führen, so dass sie ohne randseitige Überdeckung getrennt aufgewickelt werden können.

Der eigentliche Schneidvorgang kann nach mindestens zwei Methoden durchgeführt werden. Bei der ersten Methode wird das Bandmaterial über eine erste Breitstreckwalze und ggf. eine Umlenkwalze faltenfrei zur Schneideeinrichtung geführt. Die Umlenkwalze stabilisiert das Substrat.

Die Längsschneideeinrichtung umfasst mindestens ein Messer und ist unmittelbar nach der Umlenkwalze angeordnet. Das Messer taucht dabei in die Durchlaufebene des Bandmaterials ein, und zwar unmittelbar nach der Umlenkwalze im frei (ab-)laufenden Bandtrum.

Die stromab gelegene Breitstreckwalze glättet und separiert die geschnittenen Bahnen.

Nach der zweiten Methode liegt die Eintauchstelle des Messers oder der Messer der Schneideinrichtung im Bereich der stromab einer ersten Breitstreckwalze angeordneten Umlenkwalze. Letztere ist dann mit mindestens einer umlaufenden Rille oder Nut versehen, in die das Messer durch die Ebene des Bandsubstrats hindurch eintauchen kann. Somit wird das Bandsubstrat unmittelbar auf der Umlenkwalze geschnitten.

Es wäre auch denkbar, das Substrat nach Führung über eine (erste) Breitstreckwalze unmittelbar nach dem Auflaufen auf eine (zweite) Breitstreckwalze zu schneiden, und damit womöglich einen noch kompakteren Aufbau der Gesamtanlage zu schaffen. Damit könnte das Substrat unmittelbar nach dem Schneiden auf derselben Walze schon längs geteilt bzw. auseinander geführt werden.

Ferner ist es auch denkbar, die Schneidestelle unmittelbar vor dem Auflaufen des Bandmaterials auf eine Walze zu legen, so dass das Messer oder die Messer in diesem Fall den auflaufenden Trum des Bandes schneiden.

Es kommt in allen Varianten wesentlich darauf an, dass das längs aufzuschlitzende Bandmaterial im Bereich der Schneidemesser gut abgestützt ist, also entweder unmittelbar vor dem Messerbereich von einer Walze abläuft, nach dem Schnitt auf eine Walze aufläuft oder noch im Schnittbereich beiderseits auf einer Walze aufliegt, wobei das Messer in die Walzenkontur eintaucht. Sonst riskiert man, bei hohen Bandgeschwindigkeiten einen diskontinuierlichen Schnitt zu erhalten, da das Messer ggf. das Bandmaterial abdrückt und dann der Schnitt aussetzt.

Weitere Einzelheiten und Vorteile des Gegenstands der Erfindung gehen aus der Zeichnung zweier Ausführungsbeispiele und deren sich im Folgenden anschließender eingehender Beschreibung hervor.

Es zeigen in vereinfachter Darstellung
- Fig. 1: ein Blockschema einer Bandbehandlungsanlage mit einer integrierten Schneideeinrichtung;
- Fig. 2: eine erste Ausführungsform der integrierten Schneideeinrichtung, bei der ein Messer in den Umfang einer Umlenkwalze eintaucht, über die das Bandmaterial geführt wird;
- Fig. 2a: als Detail aus Fig. 2 die Umlenkwalze mit einer umlaufenden, zum Einlassen des Messers in ihren Umfang vorgesehenen Rille;
- Fig. 3: eine zweite Ausführungsform der integrierten Schneideeinrichtung, bei der ein Messer das Bandmaterial unmittelbar nach dessen Ablaufen von einer Umlenkwalze längs unterteilt.

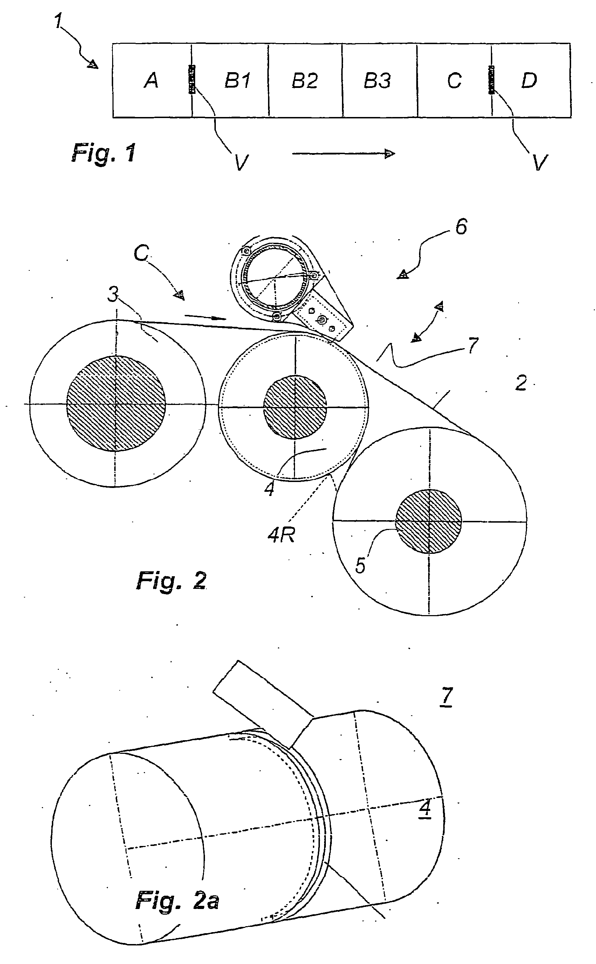

Gemäß Fig. 1 umfasst eine in Module aufgeteilte Bandbehandlungsanlage 1 einen Abwickelmodul A, in den auf einer Spule aufgewickeltes Roh-Bandmaterial eingelegt wird und sodann in Richtung des Pfeils von links nach rechts durch die Anlage geführt wird. An den Modul A schließen sich mindestens ein Behandlungsmodul B1 (ggf. weitere Behandlungsmodule B2, B3, Bx) sowie eine Schneideeinrichtung C und ein Aufwickelmodul D an.

Diese Module A bis D können im Betrieb sämtlich evakuiert werden, wenn die Behandlung des Bandmaterials (z. B. ein Magnetron-Beschichtungsverfahren, Kathodenzerstäubung, CVD) dies erfordern sollte.

In diesem Fall können zwischen einzelnen Modulen, ggf. in jedem Übergang von einem Modul zum nächsten, Schleusenventile vorgesehen werden, die es ermöglichen, die Module unabhängig von einander zu belüften bzw. zu evakuieren.

Dies gilt insbesondere für die Übergänge zu den Abwickel- bzw. Aufwickelmodulen, die zwangsläufig zum Einlegen bzw. Entnehmen der Spulen mit dem Bandmaterial periodisch immer wieder belüftet werden müssen. Repräsentativ für jede mögliche und zweckmäßige Anordnung von Schleusenventilen ist in Fig. 1 jeweils ein Schleusenventil V zwischen dem Abwickelmodul A und dem ersten Beschichtungsmodul B1 sowie zwischen der Schneideeinrichtung C und dem Aufwickelmodul D dargestellt.

Während in den Behandlungsmodulen B1, B2 etc. z. B. Beschichtungen auf das Bandmaterial aufgebracht werden, auf die hier nicht näher einzugehen ist, oder sonstige Behandlungen des Bandes durchgeführt werden, wird das Bandmaterial in der Schneideeinrichtung online, also noch innerhalb der Anlage, vorteilhaft unter Vakuum und vor dem Aufwickeln des fertig behandelten Bandmaterials im Modul D längs in mindestens zwei parallele Bahnen geschnitten.

Es wäre natürlich auch möglich, die Schneideeinrichtung vorübergehend nicht zu nutzen, d. h. die darin angeordneten Messer oder Klingen nicht mit dem Bandmaterial in Kontakt zu bringen, so dass wahlweise auch ungeschnittenes, fertig behandeltes Bandmaterial in den Aurwickelmodul D gelangt.

In jedem Fall ist im Aufwickelmodul D mindestens eine Aufwickelspule vorgesehen, wobei wahlweise das (längs unterteilte) Bandmaterial auch auf verschiedene Spulen aufgewickelt werden kann.

Es versteht sich, dass die Schneideeinrichtung C auch -abweichend von der Darstellungzwischen zwei Behandlungsmodulen Bx, By angeordnet sein könnte, so dass nach der Längsunterteilung des Bandmaterials die geteilten Bahnen weiteren Behandlungsschritten unterzogen werden können. Es wäre grundsätzlich sogar möglich, die unterteilten Bahnen nachfolgend unterschiedlichen Behandlungen zu unterziehen, so dass ausgehend von einem einheitlichen Rohmaterial schließlich unterschiedliche Endprodukte aus derselben Anlage entnommen werden könnten.

Es ist ferner denkbar, abgeteilte Bahnen -z. B. Randbahnen- aus der Anlage über Schleusenventile herauszuführen und anderweitigen Verwendungen, ggf. auch einer Resteverwertung, zuzuführen.

Während derartige Bandbehandlungsanlagen an sich als bekannt vorausgesetzt werden können, wird im Folgenden näher auf die Schneideeinrichtung eingegangen.

Gemäß Fig. 2 umfasst die von einem Bahnmaterial 2 durchlaufene Schneideeinrichtung C eine erste Breitstreckwalze 3, eine Umlenkwalze 4 und eine zweite Breitstreckwalze 5. Die Material-Laufrichtung ist wieder durch einen Pfeil oberhalb der Breitstreckwalze 3 angedeutet. Oberhalb der Umlenk- oder Stützwalze 4 erkennt man eine Schneidvorrichtung 6, welche mit mindestens einer Klinge oder einem Messer 7 bestückt ist. Mit einem Doppelpfeil rechts neben der Schneidvorrichtung 6 ist angedeutet, dass diese beweglich ist und das Messer 7 außer Eingriff mit dem Bahnmaterial 2 bringen kann.

In der hier gezeigten Stellung taucht das Messer 7 jedoch in die Durchlaufebene des Bahnmaterials 2 ein. Das Detail der Fig. 2a lässt erkennen, dass die Umlenkwalze 4 in dem betreffenden Bereich mit einer unlaufenden Rille 4R versehen ist, welche von den Bahnmaterial 2 überdeckt wird, in welche das Messer 7 jedoch unter Durchdringung und Längsaufteilung des Bahnmaterials 2 eintauchen kann.

Diese Konfiguration stellt eine gute Abstützung des durchlaufenden Bahnmaterials 2 beiderseits der kontinuierlich fortlaufenden Schneidestelle sicher, so dass nach erfolgtem Breitstrecken des Materials 2 auf der Breitstreckwalze 3- keine Verwerfungen oder Ausweichbewegungen des Bahnmaterials möglich sind. Diese Variante wird man bevorzugt für besonders dünne und nachgiebige Bandmaterialien einsetzen.

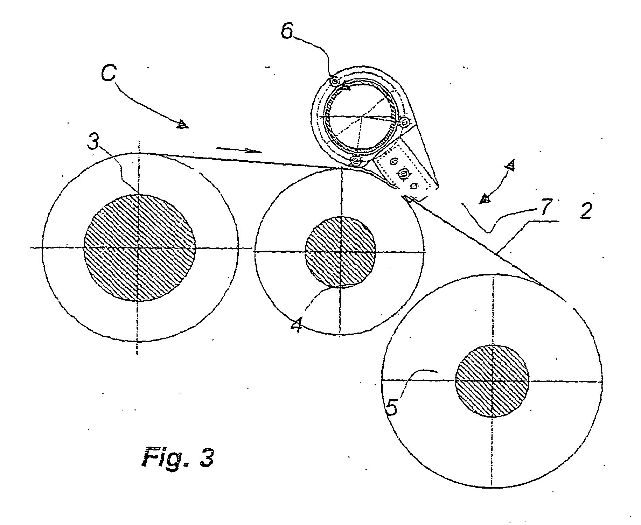

Die in Fig. 3 gezeigte Variante der Schneideeinrichtung C verzichtet auf eine Rille in der Umlenkwalze 4. Das Messer 7 der Schneidvorrichtung 6 taucht hier in unmittelbarer Nähe zu der (glatten) Oberfläche der Umlenkwalze in die Durchlaufebene des Bandmaterials 2 ein (ablaufendes Trum). Die Klinge des Messers liegt dabei praktisch tangential zu der Walzenoberfläche. Das Bandmaterial ist in dieser Nähe zur Walze nicht zu Ausweichbewegungen fähig. Man kann diese Variante, die insbesondere hinsichtlich der Umlenkwalze einfacher ausgeführt ist, vorzugsweise für relativ steife Bandmaterialien einsetzen. Auch diese Schneidvorrichtung ist vorzugsweise beweglich, wobei deren Antrieb hier nicht näher dargestellt ist.

Es versteht sich, dass die Schneidvorrichtungen im Betrieb so fest arretierbar sind, dass Beeinträchtigungen des Schneidergebnisses aufgrund von unerwünschten Relativbewegungen der Messer gegenüber der Umlenkwalze 4 nicht auftreten können.

Selbstverständlich wird man die Messer oder Klingen der Schneidvorrichtungen austauschbar gestalten; man erkennt in den Figuren, dass die Messer 7 lösbar in Haltern der Schneidvorrichtungen befestigt sind.

## Patentansprüche

1. Bandbehandlungsanlage (1), insbesondere Bandbeschichtungsanlage, mit mindestens einem von dem Bandmaterial (2) im Zuge seiner Behandlung durchlaufenen evakuierbaren Arbeitsbereich (A, B, C, D), wobei unmittelbar in dem evakuierbaren Arbeitsbereich eine Einrichtung (C) zum kontinuierlichen Längsschneiden des Bandmaterials (2) vorgesehen ist, **dadurch gekennzeichnet, dass** weiterhin wenigstens eine Breitstreckwalze (3, 5) vorgesehen ist.

2. Bandbehandlungsanlage nach Anspruch 1, **dadurch gekennzeichnet, dass** die Schneideeinrichtung (C) stromab eines Behandlungsmoduls (B) angeordnet ist.

3. Bandbehandlungsanlage nach Anspruch 1 oder 2, **dadurch gekennzeichnet, dass** die Schneideeinrichtung (C) stromab eines Behandlungsmoduls (B) und stromauf zu einem Aufwickelmodul (D) angeordnet ist.

4. Bandbehandlungsanlage nach einem der vorstehenden Ansprüche, **dadurch gekennzeichnet, dass** die Schneideeinrichtung (C) zwischen zwei unterschiedlichen Behandlungsmodulen (B1, B2, B3) angeordnet ist.

5. Bandbehandlungsanlage nach einem der vorstehenden Ansprüche, **dadurch gekennzeichnet, dass** stromab der Längsschneideeinrichtung (C) mindestens eine Breitstreckwalze (5) vorgesehen ist.

6. Bandbehandlungsanlage nach einem der vorstehenden Ansprüche, **dadurch gekennzeichnet, dass** stromauf der Längsschneideeinrichtung (C) mindestens eine Breitstreckwalze (3) vorgesehen ist.

7. Bandbehandlungsanlage nach einem der vorstehenden Ansprüche, **dadurch gekennzeichnet, dass** die Schneideeinrichtung (C) mindestens eine bewegliche Schneidvorrichtung (6) mit mindestens einem in und außer Kontakt mit dem Bandmaterial (2) bewegbaren Messer (7) umfasst.

8. Bandbehandlungsanlage nach einem der vorstehenden Ansprüche, **dadurch gekennzeichnet, dass** der Schneideeinrichtung (C) mindestens eine Umlenkwalze (4) zugeordnet ist, wobei mindestens ein Messer (7) in unmittelbarer Nähe zu der Oberfläche der Umlenkwalze (4) angeordnet ist.

9. Bandbehandlungsanlage nach Anspruch 8, **dadurch gekennzeichnet, dass** das mindestens eine Messer (7) zum Durchtrennen des von der Umlenkwalze (4) ablaufenden Trums des Bandmaterials vorgesehen ist.

10. Bandbehandlungsanlage nach Anspruch 8, **dadurch gekennzeichnet, dass** das mindestens eine Messer (7) zum Durchtrennen des auf die Umlenkwalze (4) auflaufenden Trums des Bandmaterials vorgesehen ist.

11. Bandbehandlungsanlage nach Anspruch 8 oder 9 oder 10, **dadurch gekennzeichnet, dass** die Umlenkwalze (4) mit mindestens einer umlaufenden Rille (4R) versehen ist, in welche das mindestens eine Messer (7) der Schneideeinrichtung (C) während des Schneidevorgangs eintaucht.

12. Bandbehandlungsanlage nach einem der vorstehenden Ansprüche, **dadurch gekennzeichnet, dass** sie einen Aufwickelmodul (D) umfasst, der mit einer oder mehreren Spulen zum Aufwickeln des geschnittenen Bandmaterials (2) bestückbar ist.

13. Bandbehandlungsanlage nach Anspruch 5 und 12, **dadurch gekennzeichnet, dass** die stromab der Schneideeinrichtung (C) angeordnete Breitstreckwalze (5) so ausgelegt ist, dass sie auf ihrer Oberfläche durchlaufende parallele Bahnen des geschnittenen Bandmaterials (2) zwecks getrennten Aufwickelns in Längsrichtung auseinander führt.

14. Bandbehandlungsanlage nach einem der vorstehenden Ansprüche, **dadurch gekennzeichnet, dass** zwischen einzelnen Modulen (A, B; C, D) jeweils Schleusenventile (V) vorgesehen sind.

## Claims

1. Strip treatment apparatus (1), particularly strip coating apparatus, including at least one evacuable working region (A, B, C, D), through which the strip material (2) passes in the course of its treatment, wherein provided directly in the evacuable working region there is a device (C) for continuously longitudinally cutting the strip material (2), **characterised in that** at least one spreader roll (3, 5) is also provided.

2. Strip treatment apparatus as claimed in Claim 1, **characterised in that** the cutting device (C) is arranged downstream of a treatment module (B).

3. Strip treatment apparatus as claimed in Claim 1 or 2, **characterised in that** the cutting device (C) is arranged downstream of a treatment module (B) and upstream of a winding-up module (D).

4. Strip treatment apparatus as claimed in one of the preceding claims, **characterised in that** the cutting device (C) is arranged between two different treatment modules (B1, B2, B3).

5. Strip treatment apparatus as claimed in one of the preceding claims, **characterised in that** at least one spreader roll (5) is provided downstream of the longitudinal cutting device (C).

6. Strip treatment apparatus as claimed in one of the preceding claims, **characterised in that** at least one spreader roll (3) is provided upstream of the longitudinal cutting device (C).

7. Strip treatment apparatus as claimed in one of the preceding claims, **characterised in that** the cutting device (C) includes at least one movable cutting mechanism (6) with at least one knife (7), which is movable into and out of contact with the strip material (2).

8. Strip treatment apparatus as claimed in one of the preceding claims, **characterised in that** at least one deflecting roll (4) is associated with the cutting device (C), at least one knife (7) being arranged in the immediate vicinity of the surface of the deflecting roll (4).

9. Strip treatment apparatus as claimed in Claim 8, **characterised in that** the at least one knife (7) is provided for severing the strand of the strip material moving away from the deflecting roll (4).

10. Strip treatment apparatus as claimed in Claim 8, **characterised in that** the at least one knife (7) is provided for severing the strand of the strip material moving onto the deflecting roll (4).

11. Strip treatment apparatus as claimed in Claim 8 or 9 or 10, **characterised in that** the deflecting roll (4) is provided with at least one peripheral groove (4R), into which the at least one knife (7) of the cutting device (6) extends during the cutting process.

12. Strip treatment apparatus as claimed in one of the preceding claims, **characterised in that** it includes a winding-up module (D), which may be equipped with one or more reels for winding up the cut strip material (2)

13. Strip treatment apparatus as claimed in Claims 5 and 12, **characterised in that** the spreader roll (5) arranged downstream of the cutting device (6) is so designed that it guides parallel webs of the cut strip material (2), which run over its surface, separated from one another for the purpose of separate winding-up in the longitudinal direction.

14. Strip treatment apparatus as claimed in one of the preceding claims, **characterised in that** respective gate valves (V) are provided between individual modules (A, B; C, D).

## Revendications

1. Installation de traitement de bande (1), en particulier installation de revêtement de bande, avec au moins une zone de travail pouvant être mise sous vide (A, B, C, D) parcourue par du matériau de bande (2) au cours de son traitement, dans laquelle il est prévu, directement dans la zone de travail pouvant être mise sous vide, une installation (C) pour la coupe longitudinale en continu du matériau de bande (2), **caractérisée en ce que** de plus il est prévu au moins un cylindre élargisseur (3, 5).

2. Installation de traitement de bande selon la revendication 1, **caractérisée en ce que** le dispositif de coupe (C) est disposé en aval d'un module de traitement (B).

3. Installation de traitement de bande selon la revendication 1 ou 2, **caractérisée en ce que** le dispositif de coupe (C) est disposé en aval d'un module de traitement (B) et en amont d'un module d'enroulement (D).

4. Installation de traitement de bande selon l'une des revendications précédentes, **caractérisée en ce que** le dispositif de coupe (C) est disposé entre deux modules de traitement différents (B1, B2, B3).

5. Installation de traitement de bande selon l'une des revendications précédentes, **caractérisée en ce qu'**il est prévu, en aval du dispositif de coupe longitudinale (C), au moins un cylindre élargisseur (5).

6. Installation de traitement de bande selon l'une des revendications précédentes, **caractérisée en ce qu'**en amont du dispositif de coupe longitudinale (C), est prévu au moins un cylindre élargisseur (3).

7. Installation de traitement de bande selon l'une des revendications précédentes, **caractérisée en ce que** le dispositif de coupe (C) comprend au moins un dispositif de coupe mobile (6) avec au moins une lame (7) se déplaçant en contact et hors contact avec le matériau de bande (2).

8. Installation de traitement de bande selon l'une des revendications précédentes, **caractérisée en ce qu'**au dispositif de coupe (C), est affecté au moins un cylindre de renvoi (4) dans lequel au moins une lame (7) est disposée à proximité immédiate de la surface du cylindre de renvoi (4).

9. Installation de traitement de bande selon la revendication 8, **caractérisée en ce que** la au moins une lame (7) est prévue pour la séparation du brin de matériau de bande se déroulant à partir du cylindre de renvoi (4).

10. Installation de traitement de bande selon la revendication 8, **caractérisée en ce que** la au moins une lame (7) est prévue pour la séparation du brin de matériau de bande s'enroulant sur le cylindre de renvoi (4).

11. Installation de traitement de bande selon l'une des revendications 8 ou 9 ou 10, **caractérisée en ce que** le cylindre de renvoi (4) est équipé d'au moins une gorge circulaire (4R) dans laquelle pénètre la au moins une lame (7) du dispositif de coupe (C) pendant l'opération de coupe.

12. Installation de traitement de bande selon l'une des revendications précédentes, **caractérisée en ce qu'**elle comprend un module d'enroulement (D) qui peut être équipé avec au moins une ou plusieurs bobines pour l'enroulement du matériau de bande coupée (2).

13. Installation de traitement de bande selon l'une des revendications 5 et 12, **caractérisée en ce que** le cylindre élargisseur (5) disposé en aval du dispositif de coupe (C) est conçu de telle sorte qu'il fait dévier les tronçons parallèles se déplaçant sur sa surface du matériau de bande coupée (2) pour un enroulement séparé dans la direction longitudinale.

14. Installation de traitement de bande selon l'une des revendications précédentes, **caractérisée en ce qu'**entre différents modules (A, B, C, D), sont respectivement prévues des soupapes de sas (V).
